Europäisches Patentamt

European Patent Office

Office européen des brevets

(19)

(11) **EP 1 480 047 A1**

## (12) EUROPEAN PATENT APPLICATION

(43) Date of publication:
**24.11.2004 Bulletin 2004/48**

(51) Int Cl.⁷: **G01R 31/3183**

(21) Application number: **03076584.6**

(22) Date of filing: **23.05.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **Koninklijke Philips Electronics N.V.
5621 BA Eindhoven (NL)**

(72) Inventor: **The designation of the inventor has not
yet been filed**

(74) Representative: **Dusseldorp, Jan Charles
Philips
Intellectual Property & Standards
P.O. Box 220
5600 AE Eindhoven (NL)**

### (54) Automatic test pattern generation

(57)     A method of generating digital test sets for testing a number of wiring interconnects is described. Each test set defines a number of test patterns for application to the wiring interconnects in parallel and a number of code words for application to respective wiring interconnects. Each pair of consecutive test patterns defines a transition distance which is related to a total number of bit value transitions of consecutive bits in the code words forming the pair of test patterns, and each test set has a total transition distance equal to the sum of the transition distances of said pairs of test patterns in the test set concerned. The method comprises generating a first test set in which the number of code words is greater than or equal to the number of wiring interconnects; and generating a second test set from the first test set, the number of test patterns in the second test set being equal to the number of test patterns in the first test set, and the total transition distance of the second test set being lower than that of the first test set.

FIG.3

EP 1 480 047 A1

## Description

The present invention relates to preventing ground-bounce in wiring interconnect test pattern generation algorithms.

In digital systems, there are usually a large number of wiring interconnects between components. It is an important part of the design and manufacturing process to be able to test these interconnects using known test signals. The interconnects will be referred to a "nets" in this specification.

Many test generation algorithms have been proposed previously. For example, see José T de Sousa and Peter Y K Cheung, "Boundary-Scan Interconnect Diagnosis", Kluwer Academic Publishers, Dordrecht, The Netherlands, 2001. The objective of test generation algorithms is to generate the smallest possible set of test patterns, with certain minimum detection and diagnostic properties. Fault models that are typically addressed by such test generation algorithms are single-net shorts and multiple-net bridges.

In order to test a number of interconnect wires (nets) between two or more digital components, combinations of digital test stimuli are applied to net inputs, the responses are observed at net outputs, and compared to expected responses. It is assumed that there is full control over the inputs of the nets, and that the outputs of the nets are fully observable.

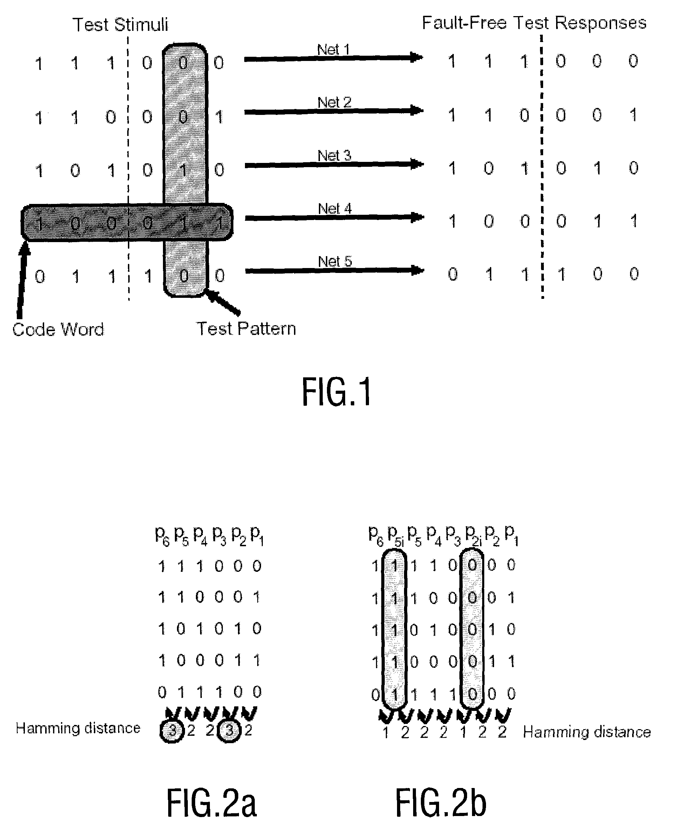

In the following description, the following terms for the test stimuli are used. These terms are illustrated in Fig. 1 of the accompanying drawings.

- *Test Pattern*: A test pattern 2 is a set of test data bits that are applied simultaneously, in parallel, to the nets under test. In Fig. 1, the test patterns are shown as the columns of the test data. Test patterns are sometimes known as Parallel Test Vectors (PTVs).

- *Code Word*: A code word 4 is the list of test data bits applied serially to an individual net during the test. In Fig. 1, code words are the rows in the test data. Code words are sometimes known as Sequential Test Vectors (STVs).

Jarwala and Jau (Najimi Jarwala and Chi W Jau, "A New Framework for Analyzing Test Generation and Diagnosis Algorithm for Wiring Interconnects", Proceedings IEEE International Test Conference (ITC), pages 63-70, October 1989) described the following deterministic fault model for wiring interconnects:

- Multi-net faults are bridging faults that create shorts between two or more nets, and which have the following characteristics:

  * *Wired-OR*: In case of dominant '1' drivers, the short behaves like a logical 'wired OR' between the shorted nets.

  * *Wired-AND*: In case of dominant '0' drivers, the short behaves like a logical 'wired AND' between the shorted nets.

  * *Strong-Driver*: A specific driver dominates the shorts, and hence the shorted nets follow the dominant driver.

- Single-net faults include "stuck-at" faults and "stuck-open" faults on a single net, have the following characteristics:

  * *Stuck-at-0*: The fault is such that the data value on the net is always read as logical '0'.

  * *Stuck-at-1*: The fault is such that the data value on the net is always read as logical '1'.

The requirement for testing shorts is that every net must get a unique code word. If the nets are fault-free, each response is unique. In case of a short, the nets involved in that short have the same response. Therefore, these responses are no longer unique and the short is detected. William Kautz (William H Kautz. Testing of Faults in Wiring Interconnects. IEEE Transactions on Computers, Vol C-23 (No 4): 358-363, April 1974) proposed a test for shorts which has become known as the Counting Sequence Algorithm. The code words are generated by a simple binary counting algorithm. For $k$ nets, $\log_2 k$ test patterns are required. The Counting Sequence Algorithm guarantees the detection of all shorts with the minimum number of test patterns.

In order to guarantee that every net is tested for stuck-at-0 opens, every code word needs to contain at least one '1'. Likewise, for stuck-at-1 faults, every code word needs to contain at least one '0'. This is not guaranteed by the Counting Sequency Algorithm. Therefore, Goel and McMahon (P Goel and M T McMahon, "Electronic Chip-In-Place Test". Proceedings IEEE International Test Conference (ITC), pages 83-90, October 1982) proposed a test generation algorithm that has become known as the Modified Counting Sequence Algorithm. The main idea is that open faults can be detected if we forbid the all-zeros and all-ones code words. Hence, for $k$ nets, $\log_2(k+2)$ test patterns are needed, which can be generated again by a simple binary counting algorithm, which starts at one, instead of at zero. The Modified Counting Sequence Algorithm guarantees the detection of all shorts and opens with the minimum number of test patterns.

Another interconnect text generation algorithm, published by Eerenstein and Muris (Lars Eerenstein and Math Muris, "Method for Generating Test Patterns to Detect an Electric Shortcircuit, a Method for Testing Electric Circuitry While Using Test Patterns So Generated, and a Tester Device for Testing Electric Circuitry with such Test Patterns", United States Patent 5,636,229), is known as the LaMa Algorithm. The LaMa algorithm is based on the Modified Counting Sequence Algorithm, but increments by three rather than by one.

The LaMa algorithm requires $\log_2(3k+2)$ test patterns for $k$ nets.

The above-mentioned test generation algorithms guarantee detection of faults. However, next to detection of faults, *diagnostic* resolution is often another important property of a test. Jarwala and Yau described the situation of *aliasing,* which obscures the diagnostic resolution. Aliasing occurs if the faulty response of a faulty net is equal to the fault-free response of another, fault-free net. In this case, we cannot determine whether the fault-free net also suffers from the fault at the fault net. Paul T. Wagner, ("Interconnect Testing with Boundary Scan", *Proceedings IEEE International Test Conference (ITC),* pages 52-57, October 1987) presented the *True/Complement Test Algorithm,* which enhances the (Modified) Counting Sequence Algorithm in order to prevent aliasing. Wagner's method applies all test patterns of the original Counting Sequence Algorithm, followed by the same test patterns with inverted values. Due to the inverted test patterns, all-zeros and all-ones code words will not be generated. Therefore, it is not necessary to exclude the numbers 0 and $k - 1$ in the counting sequence. Hence, the True/Complement Test Algorithm requires $2\log_2 k$ test patterns. The True/Complement Test Algorithm guarantees that every code word contains an equal number of zeros and ones, due to the inversion.

In case of a 'Wired-OR' fault with another net, in the response word the number of ones is increased and the number of zeros is decreased. Likewise, in case of a 'Wired-OR' fault with another net, in the response word the number of ones is increased the number of zeros is decreased. Likewise, in case of a 'Wired-AND' fault with another net, the number of zeros is increased and the number of ones is decreased. In case of a stuck-at open fault, all response values will be either all-zeros or all-ones. Hence, in every fault case the numbers of zeros and ones changes, such that the response word does not contain an equal number of zeros and ones any more. Therefore, a faulty response will never be equal to a fault-free response of another net, and hence, the True/Complement Test Algorithm is aliasing-free. In the example of Fig. 2(d), with $k = 4$, we need

$$2 \cdot \left\lceil {}^{2}\log 4 \right\rceil = 4$$

test patterns. The code words are 1100, 1001, 0110 and 0011, and they can be arbitrarily assigned to the four nets. Fig. 1 illustrates True/Complement Test Algorithm test patterns for the five nets (net 1...net 5) shown.

Recently, preventing ground bounce has become a new constraint for test generation algorithms. Ground bounce refers to the phenomenon of shifting ground and power voltage levels, for example between the IC-internal ground and power levels and those at the board, and can be caused by a large number of values switching simultaneously on an IC. Ground bounce can be prevented by introducing an upper limit on the amount of switching activity between consecutive test pattern test patterns. This limit is known as the Simultaneous Switching Output Limit (SSOL).

During the regular operation of an IC, there is much internal switching activity amongst transistors. Too much activity can cause surges in current demand from the power-supply and cause the IC-internal power or ground levels to fluctuate considerably. This in turn, can cause spurious pulses to be generated on critical signals, such as system clocks or master resets, thereby causing spurious behavior in the IC. For example, see Hans Peter Richter and Norbert Münch, "Boundary-Scan Test Triumphs Over Ground-Bounce", *Test & Measurement World Europe,* August/September 1997, or Amitava Majumdar, Michio Komoda, and Tim Ayres, "Ground Bounce Considerations in DC Parametric Test Generation using Boundary Scan", *Proceedings IEEE VLSI Test Symposium (VTS),* pages 86-91, April 1998.

Ground bounce can have a negative impact on the operation of the IC. If the IC-internal ground voltage level rises to the threshold voltage of the IC-internal logic, there exists the likelihood of invalid logic behavior. In the case of Boundary-Scan-equipped ICs, ground bounce can result in spurious test clocks (TCKs), which, in turn, can cause on-board Boundary-Scan devices to go out of synchronization.

Ground bounce can be prevented by designing ICs (or boards) such that they can handle large amounts of switching activity within the IC (or between ICs on the board). The switching activity during test is typically higher than during normal (non-test) operation. By its very nature, testing sets up sensitive paths through a circuit thereby causing many outputs to change value. In order to save test time, it is often an objective of test generation algorithms to obtain the highest possible fault coverage with a minimum number of test patterns. This increases still further the amount of internal switching activity per test pattern. ICs and boards are designed to handle ground bounce during normal operation and during test operation. In fact, the IEEE 1149.12 Boundary-Scan Standard mandates that there should be no ground-bounce inside the device during all test operations based on the use of the boundary-scan register. The problem is that at board level, with all on-board boundary-scan devices in EXTEST test mode for interconnect testing, there is no guarantee that board-level ground bounce will not occur, even though each device is within its ground bounce specification. In fact, there is a high probability that ground bounce will occur if there are more than a few thousand Boundary-Scan to Boundary-Scan interconnects.

Richter and Münch reported on ground bounce problems during EXTEST testing between 1149.1-compliant ASICs on an industrial telecommunications board. All the ASICs met their electrical ground bounce specification and simulation confirmed correct operation of the ASICs under normal operation with at most 50% of the ASIC outputs switching simultaneously. The ASIC designers did not consider the possibility that many (or even all) boundary-scan outputs might switch simultaneously (worst-case EXTEST), even though that was what happened during board testing.

Ground bounce can be prevented at board level by controlling the degree of switching activity in the test patterns generated and applied across the interconnects. This can be done by introducing an upper limit on how many Boundary-Scan outputs can be simultaneously switched in the transition from one test pattern to the next. In this description, this upper limit is referred to as the *Simultaneously-Switching Outputs Limit* (SSOL). In general, the SSOL should be derived and defined by the board designer responsible for the electrical design of the board. Many vendors of board-level interconnect ATPG tools have added SSOL constraints into their products.

The SSOL constraint restricts the maximum number of data bit transitions between two consecutive test patterns. The number of bit transitions between consecutive test patterns is known as the Hamming distance, and is illustrated in Fig. 2. In Fig. 2(a) six test patterns ($p_1$ to $p_6$) are shown and the Hamming distances between consecutive test patterns are also shown. It can be seen that two of the consecutive pairs of test patterns have Hamming distances greater than assumed level of SSOL of 2.

It is therefore necessary to modify the test patterns in order to remove these violations. A previously-considered method for removing the violations is to insert additional test patterns between the violating pairs of test patterns. In the present case, as shown in Fig. 2 (b), two additional test patterns $p_{2i}$ and $p_{5i}$ are added to remove these violations. All of the pairs of test patterns in Fig. 2(b) have Hamming distances less than the SSOL level.

However, incorporating an SSOL constraint into test generation generally leads to an increase in the number of test patterns, and hence test time, because of the need to insert additional test patterns.

It is therefore desirable to provide a test pattern generation algorithm that can incorporate a SSOL constraint, but that also minimizes the number of test patterns to be generated.

Embodiments of the present invention therefore seeks to provide such an algorithm, to provide a method that allows incorporation of SSOL-violation-free consecutive test patterns into any given test generation algorithm.

According to one aspect of the present invention, there is provided a method of generating digital test sets for testing a number of wiring interconnects, each test set comprising a matrix of bits, which matrix defines a first plurality of test patterns and a second plurality of code words, wherein the bits of each test pattern are for application to respective wiring interconnects in parallel with one another, and the bits of successive test patterns for application to an interconnect form a code word for that interconnect, and wherein each pair of consecutive test patterns defines a transition distance which is related to a total number of bit value transitions of consecutive bits in the code words forming the pair of test patterns, and wherein each test set has a total transition distance equal to the sum of the transition distances of said pairs of test patterns in the test set concerned, the method comprising the steps of:

- generating a first test set in which the number of code words is greater than or equal to the number of wiring interconnects; and
- generating a second test set from the first test set, the number of test patterns in the second test set being equal to the number of test patterns in the first test set, and the total transition distance of the second test set being lower than that of the first test set.

Fig. 1 illustrates test patterns and code words;
Fig. 2 illustrates test stimuli for five nets for the True/Complement Test Pattern Generation Algorithm;
Fig. 3 illustrates a method embodying one aspect of the present invention;
Fig. 4 illustrates a first method of code word subset selection;
Fig. 5 illustrates a second method of code word subset selection;

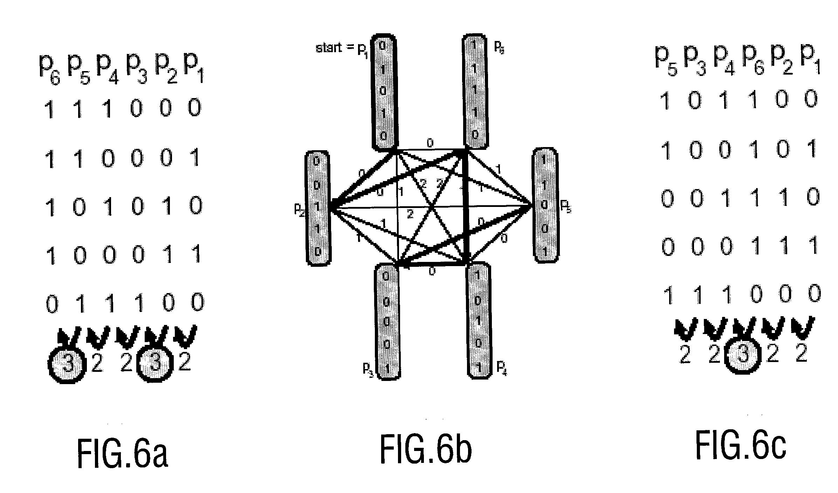

Fig. 6 illustrates a method for reordering test patterns; and

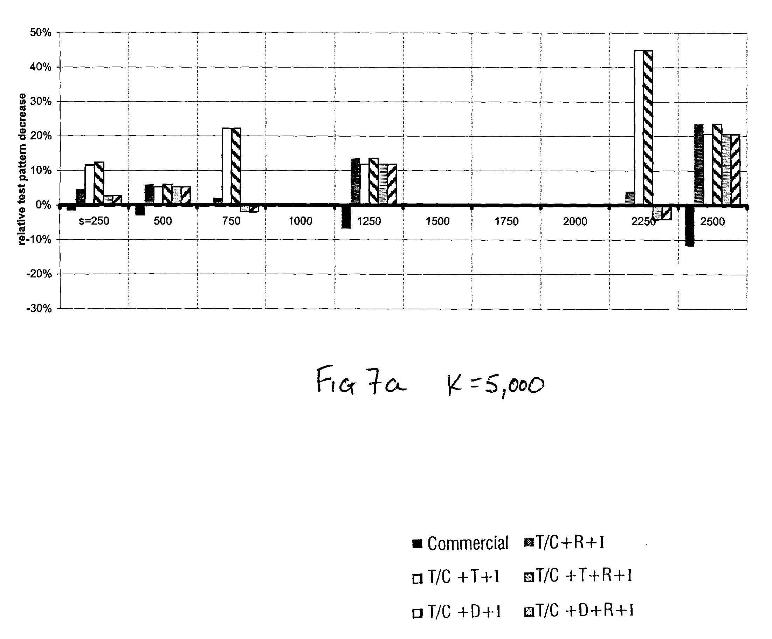

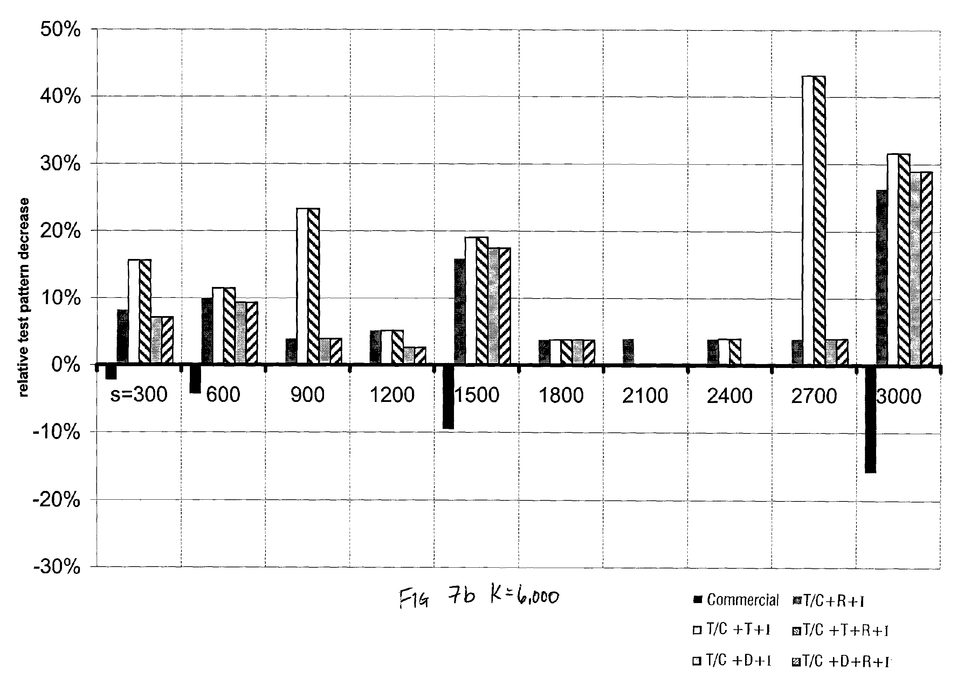

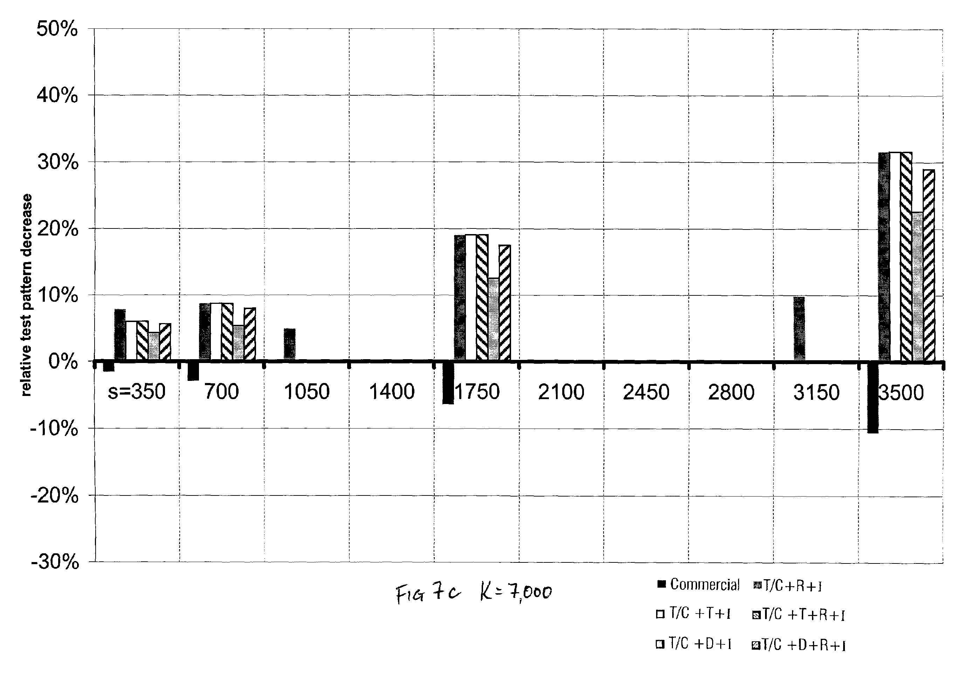

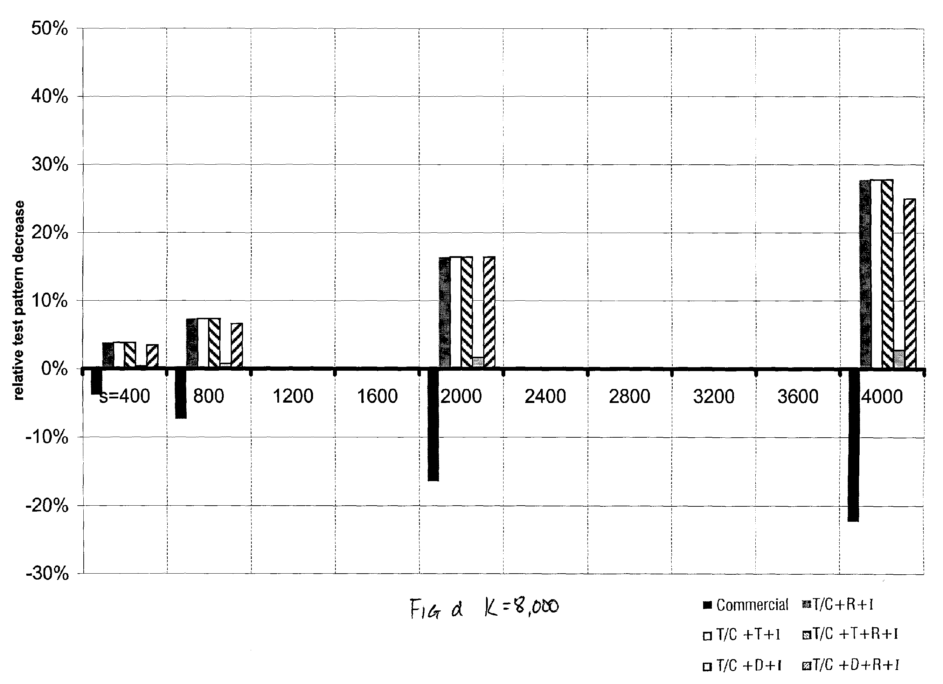

Fig. 7 illustrates test pattern count reductions.

Embodiments of the present invention provide methods that allow incorporation of SSOL-violation-free consecutive test patterns into test generation algorithms.

The methods according to the present invention use a set of test patterns generated using a test pattern generation algorithm, and then subject this set to further processing.

The invention will be described with reference to the True/Complement Test Pattern generation algorithm described above, but it will be readily appreciated that embodiments of the invention are able to operate on test patterns generated by any algorithm or approach.

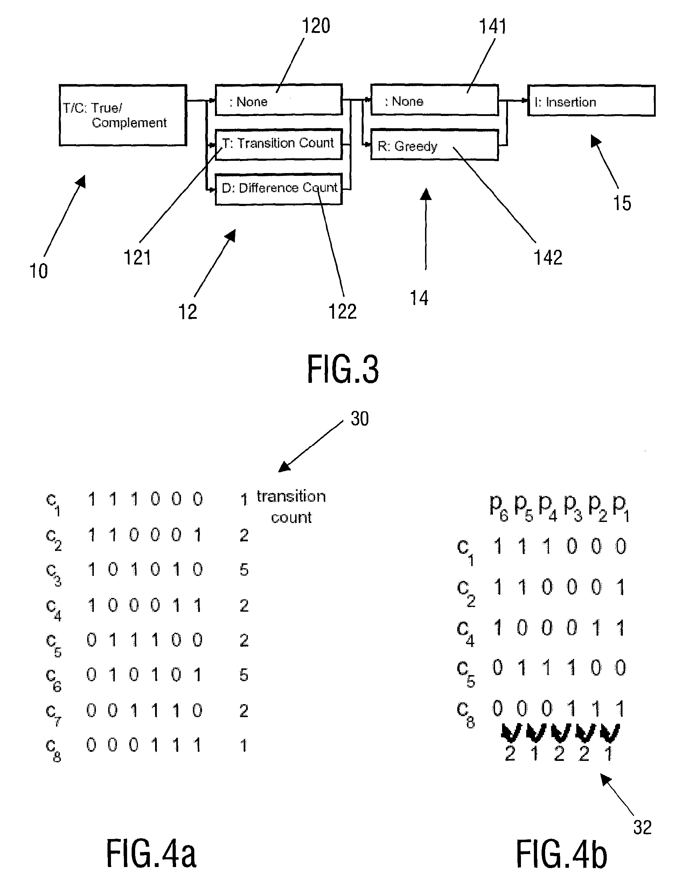

A method embodying the present invention uses two basic steps : code word subset selection, and test pattern re-ordering (and insertion). The overall method is illustrated in Fig. 3. At step 10, an automatic test pattern generation algorithm is used to generate a complete set of test patterns.

At step 12(120, 121, 122) code word subset selection is performed using any method (120), a transition count method (121), or a difference count method (122). The results of the selection are fed to a re-ordering step 14 which reorders the test patterns using any method (141), or a greedy method (142) to minimize the number of SSOL violations in the test pattern set. The various methods will be described in more detail below.

Following reordering, additional test patterns can be inserted where necessary (step 15) in order to remove any remaining SSOL violations.

The selection of a code word subset will now be described in more detail.

For *k* nets, a test generation algorithm requires $p(k)$ test patterns. With $p(k)$ test patterns, the algorithm generates $c(k)$ unique code words, such that $k \leq c(k)$. The functions $p(k)$ and $c(k)$ depend on the test generation algorithm. For example, for the True/Complement Test Algorithm p(k) and c(k) are given by the following:

$$p(k) = 2\log_2 k$$

$$c(k) = 2^{p(k)/2} = 2_2^{\log k}$$

In many practical cases, the algorithm generates more code words than strictly necessary, i.e., $k < c(k)$, because $k, p(k),$ and $c(k)$ are all integers. This means that the expressions have ceil operators that round off any non-integer values to the nearest higher integer values. These ceil operators cause that in many cases $k < c(k)$.

Accordingly, it is possible to choose a subset of the total number c(k) of generated code words to be applied during the test. Such subset selection will not affect the detection and diagnostic properties of a test, or test time.

There are

$$\binom{c(k)}{k} = \frac{c(k)!}{k! \cdot (c(k)-k)!}$$

possible subsets available from which to choose. As an example, consider the True/Complement Test Algorithm for $k = 257$. According to the above, $c(257) = 2^{\log_2 257} = 2^9 = 512$. Therefore, there are

$$\binom{512}{257} \approx 4.7 \times 10^{152}$$

alternative code word subsets.

The subset selection procedure searches for the subset of code words that leads to the smallest test pattern set without SSOL violations.

According to the present invention, the code word subset selection can be performed by one of two heuristic techniques, which will be described below.

The first possible heuristic technique is based upon a transition count, and is illustrated in Fig. 4. The example of Fig. 4 represents the case for k=5, which yields 6 test patterns and eight code words. In Fig. 4(a) a complete set ($c_1$ to $c_8$) of test patterns is shown, together with the count 30 of the number of bit transitions therein. Using the transition count heuristic method, the k(=5) code words that are required are selected as the 5 code words having the lowest transitions counts. Where only a selection of code words having the same transition count is required, the selection is made arbitrarily.

Fig. 4(b) illustrates the selected code words ($c_1$ $c_2$ $c_4$ $c_5$ $c_8$), together with the Hamming distances 30 between consecutive test patterns. In this case, it can be seen that the subset form a test pattern set that has no violations for SSOL=2, and so no further processing would be required. Naturally, and especially for large values of k, reordering and possible insertion could be required.

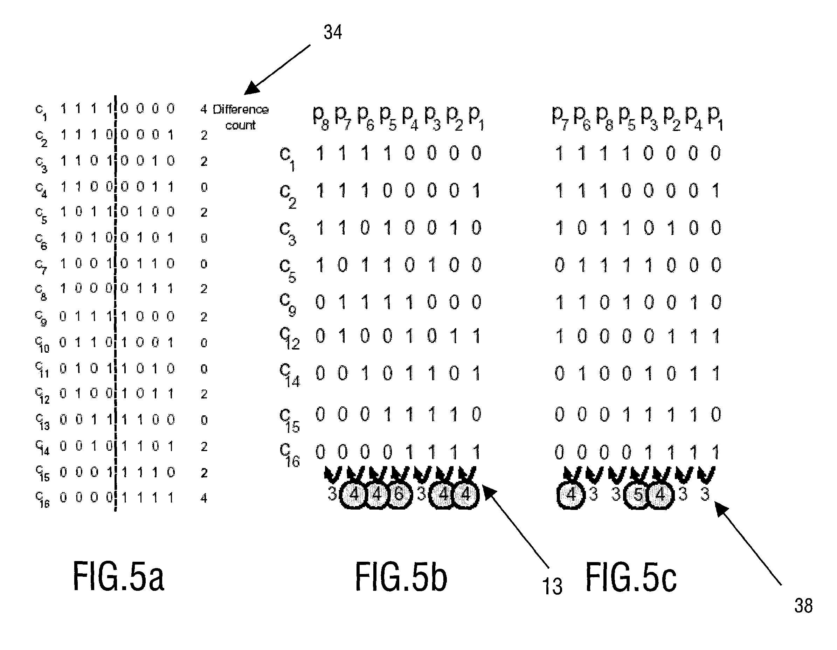

The second heuristic approach uses a difference count method, and this is illustrated in Fig. 5. Fig. 5(a) shows a complete test pattern set ($c_1$ to $c_{16}$), for the situation when k=9, and SSOL=3, generated using the True/Complement method. Each code word has an associated difference count, which is equal to the differences in number of ones and zeros in one half of the code word. The difference count can be applied to a code word produced by other methods apart from the True/Complement method, in which case the count relates to the difference in number of ones and zeros in the code word itself.

The code words having the lowest difference counts are then selected to provide the correct number k of code words. When a selection between code words having the same difference count is to be made, this selection is made on an arbitrary basis. Fig. 5(b) shows the selected subset of code words, together with the Hamming distances between consecutive pairs of test patterns. It can be seen that test patterns several of the test pattern pairs fail the SSOL<=3 test, and so further processing will be required. The results of the further processing (reordering), to be described in detail below, are shown in Fig. 5(c).

Reordering and insertion of the test patterns will now be described in more detail.

Reordering of the test patterns is carried out on the subset of code words selected during the previous stage. Accordingly, there are *p* test patterns and *k* code words.

Initially, a so-called *SSOL Violations Graph* is constructed. Such a graph is shown in Fig. 5 and comprises a weighted, fully-connected, and undirected graph. The nodes of the graph correspond to the p(k) test patterns. The edge between each pair of nodes is given a weight dependent upon the hamming distance between the nodes in the pair. The weight of an edge represents the number of SSOL violations between those two nodes.

The problem of finding the route through the nodes of the graph can be seen to be a version of the traveling salesman problem (TSP). In terms of the SSOL Violations Graph, it is necessary to find a route through all nodes of the graph, such that the summed weight of the edges encountered along the tour is minimized.

This problem is equal to the optimization variant of the well-known *Traveling Salesman Problem,* M. R. Garey and D.S. Johnson, *Computers and Intractability -A guide to the theory of NP-Completeness,* W.H. Freeman and Company, San Francisco, CA, USA, 1979.

The Traveling Salesman Problem (TSP) is briefly described, and can be summarized as follows. Given a set $C$ of $m$ cities, with distances $d(c_i, c_j)$ for each pair of cities $c_i, c_j \in C$, and a positive integer $B$. Is there a tour of $C$ having length $B$ of less?

In practical terms, the time needed to compute an optimal solution increase exponentially with the problem instance size. The problem instance size is determined by the number of nodes (test patterns). Fortunately, the problem instance size for board-level interconnect testing is not very large. The number of test patterns is of the order of $\log_2 k$, and hence, even for boards with thousands of nets, there are between 10 to 20 test patterns. Therefore, it seems feasible for most practical problem instances to solve this problem exhaustively, i. e., by enumerating all possible tours in the graph. Alternatively, there are effective and efficient heuristic algorithms for TSP available in the literature, that are able to solve this problem with close-to-optimal solutions in short compute times. For example, see David .S Johnson and Lyle A. McGeoch, "The traveling salesman problem: A case study", in Emile H.L Aarts and Jan-Karel Lenstra, editors, *"Local Search in Combinatorial Optimization",* pages 215-310, John Wiley & Sons Ltd., Chichester, England 1997.

Fig. 5(b) illustrates a SSOL violations graph for k=5, and s=2, with Fig. 5(a) showing the unordered test pattern set that makes up the nodes of the graph. It can be seen that the unordered test pattern set has two instances of pairs of test patterns which violate the SSOL criterion.

In Fig. 5(b) bold arrows indicate the SSOL-violation-free tour through the graph. Fig. 5(c) shows the corresponding resultant test set, in which the test patterns are ordered according to the minimized SSOL-violation tour in the graph.

After running a TSP Solver, there are two possible outcomes: (1) a tour with summed weight zero is obtained, or (2) a tour with summed weight larger than zero is obtained. In the first case, an ordering of the test patterns that meets the SSOL constraint has been found. In the latter case, an ordering of the test patterns has been found that still has one or more SSOL violations. This might be due to the fact that there is not tour with summed weight zero, or there is such a tour, but the heuristic TSP solver used was not capable of finding it. In any case, it is expected that the number of SSOL violations is relatively low, as minimizing the summed weight of the tour was the objective function of the TSP Solver.

Remaining SSOL violations case be resolved by inserting one or more additional test patterns in between two consecutive test patterns that have an SSOL violation. If consecutive test patterns $p_1$ and $p_2$ have w $(p_1, p_2)$ SSOL violations (with w$(p_1, p_2)>0$), then it is necessary to insert w$(p_1, p_2)$/s additional test patterns in order to resolve all SSOL violations between those two patterns.

In Fig. 5(c), it can be seen that one pair of test patterns violate the SSOL criterion, and so an additional test pattern must be inserted between those two test patterns to remove this violation.

It will be appreciated that methods embodying the present invention allow an SSOL constraint to be included in an automatic test pattern generation algorithm, and that the algorithm can provide a minimal number of test patterns for use in the testing procedure.

Although the embodiments of the invention have been described with reference to a True/Complement code word, it will be appreciated that the principle of the present invention can be applied to any code word. In particular, it is possible to perform the processing according to the invention on a code word set, and then add the complement of the final set, to produce a true/complement test set.

## Claims

1. A method of generating digital test sets for testing a number of wiring interconnects, each test set comprising a matrix of bits, which matrix defines a first plurality of test patterns and a second plurality of code words, wherein the bits of each test pattern are for application to respective wiring interconnects in parallel with one another, and the bits of successive test patterns for application to an interconnect form a code word for that interconnect, and wherein each pair of consecutive test patterns defines a transition distance which is related to a total number of bit value transitions of consecutive bits in the code words forming the pair of test patterns, and wherein each test set has a total transition distance equal to the sum of the transition distances of said pairs of test patterns in the test set concerned, the method comprising the steps of:

   - generating a first test set in which the number of code words is greater than or equal to the number of wiring interconnects; and
   - generating a second test set from the first test set, the number of test patterns in the second test set being equal to the number of test patterns in the first test set, and the total transition distance of the second test set being lower than that of the first test set.

**2.** A method as claimed in claim 1, wherein the second test set has a lower number of transition distances that exceed a threshold value than the first test set.

**3.** A method as claimed in claim 2, wherein the second test set has a minimum number of transition distances that exceed the threshold level.

**4.** A method as claimed in claim 3, wherein the second test set has no transition distances that exceed the threshold value.

**5.** A method as claimed in any one of the preceding claims, wherein generating the second test set comprises selecting, as the second test set, a subset of the code words of the first test set.

**6.** A method as claimed in any one of claim 5, wherein selecting a subset of the first set of code words comprises:

- determining the number of bit transitions occurring in each code word; and
- selecting a subset of code words that has a reduced sum of such bit transitions compared to the first test set.

**7.** A method as claimed in claim 6, wherein the selected subset has a minimized sum of bit transitions.

**8.** A method as claimed in claim 5, wherein selecting a subset of code words comprises:

- determining a difference count for each code word, a difference count relating to the difference in number of high and low bit values in the code word concerned; and
- selecting a subset of code words that has a reduced sum of difference counts for the subset compared to the first test set.

**9.** A method as claimed in claim 8, wherein the selected subset has a minimized sum of difference counts.

**10.** A method as claimed in any one of the preceding claims, wherein generating the second test set comprises re-ordering the test patterns of the first test set to form the second test set.

**11.** A method as claimed in claim 10, wherein the re-ordering is performed using a Traveling Salesman Algorithm, using test patterns as destinations and transition distances as distance values between destinations.

**12.** A method as claimed in any one of the preceding claims, wherein the number of code words in the second test set is equal to said number of wiring interconnects.

**13.** A method as claimed in any one of the preceding claims, further comprising adding additional test patterns to the second test set.

**14.** A method as claimed in claim 13, wherein adding additional test patterns comprises inserting additional test patterns between pairs of test patterns that have an original transition distance greater than a threshold value, the inserted test patterns causing transition distances which are less than the original transition distance.

**15.** A method as claimed in claim 14, wherein the inserted test patterns cause transition distances that are less than or equal to a predetermined threshold level.

**16.** A method as claimed in claim 13, wherein adding additional test patterns comprises adding the complement of the second test set to the second test set to form a final true/complement test set.

**17.** A method of testing a number of wiring interconnects, the method comprising the steps of:

- applying a test set, generated in accordance with a method as claimed in any one of the preceding claims, to a plurality of wiring interconnects; and
- analyzing the results of such application.

Test Stimuli       Fault-Free Test Responses

**FIG.1**

**FIG.2a**      **FIG.2b**

120    141

| T/C: True/ Complement | : None | : None | I: Insertion |

T: Transition Count

D: Difference Count

R: Greedy

10    121    12    122    14    142    15

## FIG.3

30

| $c_1$ | 1 1 1 0 0 0 | 1 transition count |
| $c_2$ | 1 1 0 0 0 1 | 2 |
| $c_3$ | 1 0 1 0 1 0 | 5 |
| $c_4$ | 1 0 0 0 1 1 | 2 |
| $c_5$ | 0 1 1 1 0 0 | 2 |
| $c_6$ | 0 1 0 1 0 1 | 5 |
| $c_7$ | 0 0 1 1 1 0 | 2 |
| $c_8$ | 0 0 0 1 1 1 | 1 |

## FIG.4a

$p_6$ $p_5$ $p_4$ $p_3$ $p_2$ $p_1$

| $c_1$ | 1 1 1 0 0 0 |
| $c_2$ | 1 1 0 0 0 1 |
| $c_4$ | 1 0 0 0 1 1 |
| $c_5$ | 0 1 1 1 0 0 |
| $c_8$ | 0 0 0 1 1 1 |

2 1 2 2 1

32

## FIG.4b

FIG.5a

FIG.5b

FIG.5c

EP 1 480 047 A1

$P_6$ $P_5$ $P_4$ $P_3$ $P_2$ $P_1$

1 1 1 0 0 0

1 1 0 0 0 1

1 0 1 0 1 0

1 0 0 0 1 1

0 1 1 1 0 0

3 2 2 3 2

**FIG.6a**

start = $p_1$

**FIG.6b**

$P_5$ $P_3$ $P_4$ $P_6$ $P_2$ $P_1$

1 0 1 1 0 0

1 0 0 1 0 1

0 0 1 1 1 0

0 0 0 1 1 1

1 1 1 0 0 0

2 2 3 2 2

**FIG.6c**

Fig 7a    K = 5,000

FIG 7b K=6,000

FIG 7c  K=7,000

■ Commercial  ▨ T/C+R+I
▢ T/C +T+I  ▧ T/C +T+R+I
▢ T/C +D+I  ▨ T/C +D+R+I

Fig. d  K = 8,000

**European Patent Office**

**EUROPEAN SEARCH REPORT**

Application Number

EP 03 07 6584

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | MARINISSEN E J ET AL: "MINIMIZING PATTERN COUNT FOR INTERCONNECT TEST UNDER A GROUND BOUNCE CONSTRAINT" IEEE DESIGN & TEST OF COMPUTERS, IEEE COMPUTERS SOCIETY. LOS ALAMITOS, US, vol. 20, no. 2, 1 March 2003 (2003-03-01), pages 8-18, XP001164746 ISSN: 0740-7475 * the whole document * --- | 1-17 | G01R31/3183 |
| X | MARINISSEN ET AL.: "Incorporating A Ground Bounce Preventing Constraint into Wiring Interconnect Test Pattern Generation Algorithms" PROC. IEEE INT. BOARD TEST WORKSHOP , 11 October 2002 (2002-10-11), XP002259063 * the whole document * ----- | 1-17 | |

TECHNICAL FIELDS SEARCHED (Int.Cl.7)

G01R

The present search report has been drawn up for all claims

| Place of search | Date of completion of the search | Examiner |
|---|---|---|
| MUNICH | 3 November 2003 | Böhm-Pélissier, A |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document